# EUROPÄISCHE PATENTSCHRIFT

(11) **EP 0 902 346 B1**
(45) Veröffentlichungstag und Bekanntmachung des Hinweises auf die Patenterteilung: **04.12.2002**
(21) Anmeldenummer: 98116594.7
(22) Anmeldetag: 02.09.1998
(51) Int. Cl.: G05B 19/418, H05K 7/14

(54) **Modulares feldbusgesteuertes Automatisierungsgerät**
Modular field bus controlled automation device
Dispositif d'automation modulaire controllé par bus de secteur

(30) Priorität: 15.09.1997 DE 29716575 U
(43) Veröffentlichungstag der Anmeldung: 17.03.1999
(73) Patentinhaber: SIEMENS AKTIENGESELLSCHAFT, 80333 München (DE)
(72) Erfinder: Bräunlich, Michael, Dipl.-Ing., 09117 Chemnitz (DE); Fügmann, Frank, Dipl.-Ing., 09114 Chemnitz (DE); Glöckner, Knut, Dipl.-Ing., 09113 Chemnitz (DE); Meier, Frank Günter, Dipl.-Ing., 09212 Limbach-Oberfrohna (DE); Hofmann, Jörg, Dipl.-Ing., 09648 Altmittweida (DE)

(56) Entgegenhaltungen:
- DE-C- 4 438 806

## Beschreibung

Die vorliegende Erfindung betrifft ein feldbusgesteuertes Automatisierungsgerät zur Steuerung und/oder Überwachung eines technischen Prozesses.

Bei feldbusgesteuerten Automatisierungsgeräten sind sowohl kompakte als auch modulare Aufbauformen bekannt. Das Problem der stehenden Verdrahtung (schnelles und sicheres Auswechseln von Baugruppen bei Defekten oder Um- bzw. Nachrüstungen ohne die Notwendigkeit des Lösens von Drähten) ist bei kompakten Bauformen z.B. dadurch gelöst, daß die Baugruppen aus zwei Komponenten aufgebaut werden, einem festen Teil, der die Verdrahtung trägt, und einem wechselbaren Elektronikmodul.

Bei modularen kanalgranularen Aufbauformen sind die Klemmen Bestandteil des einzelnen Funktionsmoduls, so daß beim Auswechseln eines Funktionsmoduls die an den Klemmen aufgelegten Kabel gelöst werden müssen, so daß eine stehende Verdrahtung nicht gegeben ist.

Aus der DE 44 38 806 ist ein modulares Steuerungssystem mit einem aus einzelnen Anschlußscheiben gebildeten Anschlußblock, einem Feldbusanschlußmodmodul und einem auf den Anschlußblock aufsteckbaren Elektronikmodul bekannt.

Die Aufgabe der vorliegenden Erfindung besteht darin, ein feldbusgesteuertes Automatisierungsgerät anzugeben, daß sowohl kompakt als auch kanalgranular aufgebaut werden kann, und das nur in einer definierte Verhältnisse nach sich ziehenden Weise kontaktierbar ist.

Diese Aufgabe wird mit einem feldbusgesteuerten Automatisierungsgerät der oben genannten Art mit einem Basismodul, einem Kopfmodul mit Außenkontakten und mindestens einem Funktionsmodul ohne Außenkontakte, wobei das Kopfmodul bzw. das Funktionsmodul mit dem Basismodul elektrisch leitend kontaktierbar ist, wobei die Außenkontakte des Kopfmoduls zum Anschließen einer Spannungsversorgung und/oder zum kommunikativen Verbinden mit weiteren elektrischen Geräten vorgesehen sind, wobei das Kopfmodul zur Ansteuerung des mindestens einen Funktionsmoduls wirksam ist und wobei das Basismodul Außenkontakte zum Anschließen externer Geräte - insbesondere Aktoren oder Sensoren zur Steuerung und /oder des technischen Prozesses - aufweist, die einem Funktionsmodul räumlich zugeordnet sind und mit diesem elektrisch leitend verbunden sind, dadurch gelöst, daß die Außenkontakte des Kopfmuduls räumlich zueinander derart angeordnet sind, daß sich beim Kontaktieren der Außenkontakte ein konstruktionsbedingt zwangsweiser Handlungsablauf ergibt. Damit ist ein Kontaktieren des Kopfmoduls nur in einer definierte Verhältnisse nach sich ziehenden Weise möglich. So kann z.B. der Außenkontakt für den Masse-und/oder Schirmanschluß nur kontaktiert werden, bevor die Außenkontakte für die Versorgungsspannung und die kommunikative Verbindung kontaktiert sind.

Wenn das Basismodul Aufnahmepositionen zur Aufnahme des mindestens einem Funktionsmoduls aufweist, die eine bündige Anordnung benachbarter Funktionsmodule ermöglichen, ist eine besonders kompakte Bauform des Automatisierungsgerätes einerseits und eine gegenseitige Stabilisierung der jeweils benachbarten Funktionsmodule andererseits ermöglicht.

Wenn darüber hinaus ein elektrisches bzw. mechanisches Kontaktieren bzw. Dekontaktieren des Kopfmoduls mit dem Basismodul nur unter Einhaltung des konstruktionsbedingt zwangsweisen Handlungsablaufs beim Kontaktieren bzw. Dekonaktieren der Außenanschlüsse des Kopfmoduls möglich ist, ist z.B. sichergestellt, daß das Kopfmodul nur in spannungslosem Zustand vom Basismodul gelöst wird.

Auf diese Weise läßt sich ebenfalls ein in bezug auf die kommunikative Verbindung, einen Bus, rückwirkungsfreies Zu- und Abschalten bestimmter Busteilnehmer erreichen, denn vor dem Abschalten des Busteilnehmers, des Kopfmoduls, ist erfindungsgemäß zwangsweise das Dekontaktieren des Außenanschlusses zur kommunikativen Verbindung erforderlich. Auswirkungen auf den derart abgetrennten Bus die ansonsten z.B. durch das Abschalten der Versorgungsspannung oder durch das Dekontaktieren des Kopfmoduls von dem Basismodul hervorgerufen werden könnten, sind auf diese Weise ausgeschlossen.

Ein Ausführungsbeispiel der Erfindung wird nachstehend anhand der Zeichnung näher erläutert. Dabei zeigen:

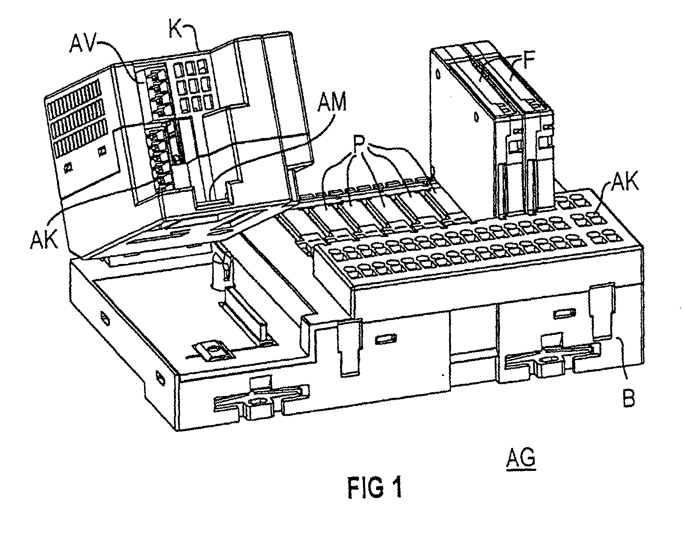

- FIG 1: ein feldbusgesteuertes Automatisierungsgerät und
- FIGen 2 bis 5: den konstruktionsbedingt zwangsweisen Handlungsablauf beim Kontaktieren und Dekontaktieren der Außenanschlüsse des Kopfmoduls.

Gemäß FIG 1 besteht das Automatisierungsgerät AG zumindest aus einem Basismodul B, einem mit diesem elektrisch und mechanisch lösbar verbindbaren Kopfmodul K und mindestens einem mit dem Basismodul B elektrisch und mechanisch lösbar verbindbaren Funktionsmodul F.

Das Basismodul B weist weiterhin Außenkontakte A auf, die ein Anschließen externer Geräte, insbesondere der genannten Aktoren oder Sensoren, zur Steuerung und/oder Überwachung des technischen Prozesses ermöglichen. Gleichfalls weist das Kopfmodul K Außenkontakte zum Anschließen einer Spannungsversorgung und/oder zum kommunikativen Verbinden mit weiteren elektrischen Geräten auf, die jedoch in der FIG nicht ersichtlich sind. Das Funktions- oder Elektronikmodul F ist an einer Aufnahmeposition P des Basismoduls B angeordnet.

Das Basismodul B weist im Ausführungsbeispiel eine Vielzahl von Aufnahmepositonen P zur Aufnahme jeweils eines Funktionsmoduls F auf. Das Funktionsmodul F weist selbst keine Außenkontakte auf, sondern ist in einem kapselförmigen Gehäuse eingeschlossen, aus dem die Kontaktmittel zum elektrisch leitenden Kontaktieren mit entsprechenden Gegenkontaktmitteln des Basismoduls B herausragen.

Auch das Kopfmodul K ist in einem Gehäuse gekapselt, das Öffnungen zum Kontaktieren der Außenkontakte bzw. Öffnungen für ein Kontaktmittel zum Kontaktieren mit dem entsprechenden Kontaktmitteln des Basismoduls B aufweist. Das Kopfmodul K ermöglicht damit eine stehende Verdrahtung und ist einfach lösbar. Durch eine einheitliche Schnittstelle können Kopfmodule K für jeweils unterschiedliche Bussysteme zum kommunikativen Verbinden mit anderen elektrischen Geräten aufgesteckt werden. Da das Kopfmodul K keine Peripherieelektronik enthält, ergibt sich eine günstige Struktur bezüglich der Trennung Elektronik und Peripherie, und damit eine bessere Entwärmung und bessere EMV-Festigkeit.

Im Ausführungsbeispiel sind die Außenkontakte AV, AK,AM des Kopfmoduls K zum Anschluß der Versorgungsspannung AV und der Buskommunikation AK so angeordnet, daß die mechanische Verbindung zum Basismodul B durch die mit den Außenkontakten AV, AK, AM kontaktierten Kontaktelementen KV, KK, KM verdeckt wird. Dies erfordert bei Montage bzw. Demontage eine bestimmte, durch die räumliche Anordnung der Kontakte AV, AK, AM festgelegte Reihenfolge beim Herstellen bzw. Lösen der elektrischen und mechanischen Verbindungen. Der damit bewirkte konstruktionsbedingt zwangsweise Handlungsablauf beim Kontaktieren und Dekontaktieren der Außenanschlüsse AV, AK, AM des Kopfmoduls ist in den FIGen 2 bis 5 dargestellt.

Damit wird eine hohe Sicherheit bei der Inbetriebnahme bzw. Deinstallation des gesamten Automatisierungsgerätes AG erreicht, da die Reihenfolge der Arbeitschritte unabhängig von der eventuellen Beachtung im Handbuch dokumentierter Arbeitsschritte ist.

Für das Lösen das Kopfmoduls K ergeben sich konstruktionsbeding zwangsweise die nachfolgenden Arbeitsschritte:

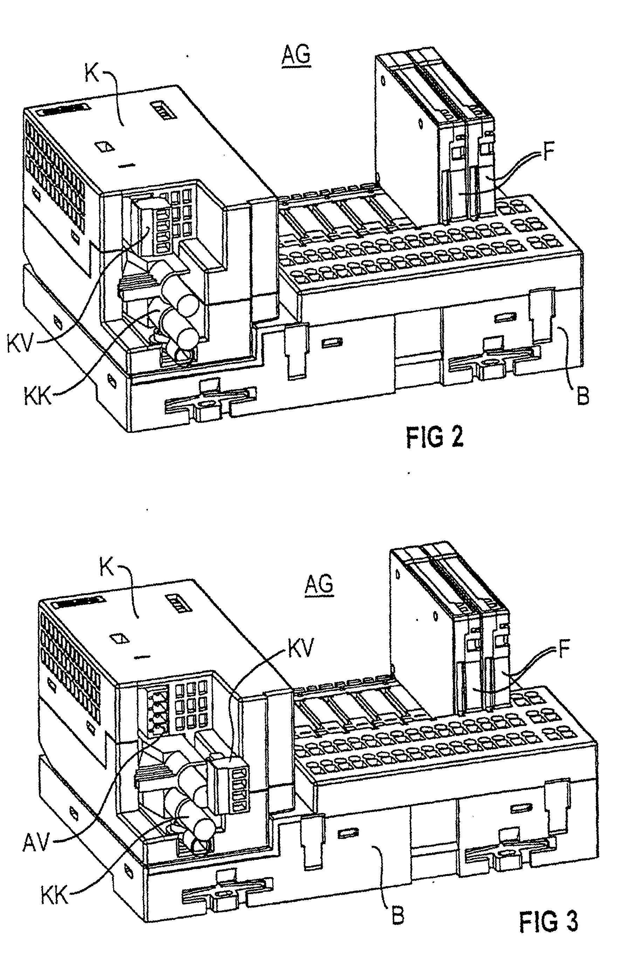

- FIG 2:: Abtrennen der Versorgungsspannung KV. Dadurch wird das Automatisierungsgerät AG über einen "Reset"-ähnlichen Vorgang in einen sicheren Zustand gebracht. D.h. die vom Kopfmodul K angesteuerten Funktionsmodule F werden in den vom jeweiligen Funktionstyp abhängigen sicheren passiven Zustand überführt. Gleichzeitig kann - über die noch bestehende kommunikative Verbindung AK, KK - in der verbleibenden Zeit bis zum Abklingen der gestützten Spannung im Kopfmodul K eine Mitteilung an ein hierarchisch dem Automatisierungsgerät AG übergeordnetes Automatisierungsgerät erfolgen, so daß hier je nach Bedarf die entsprechende Reaktion im übergeordneten System ausgelöst werden kann.
- FIG 3:: Abtrennen der kommunikativen Verbindung AK, KK.

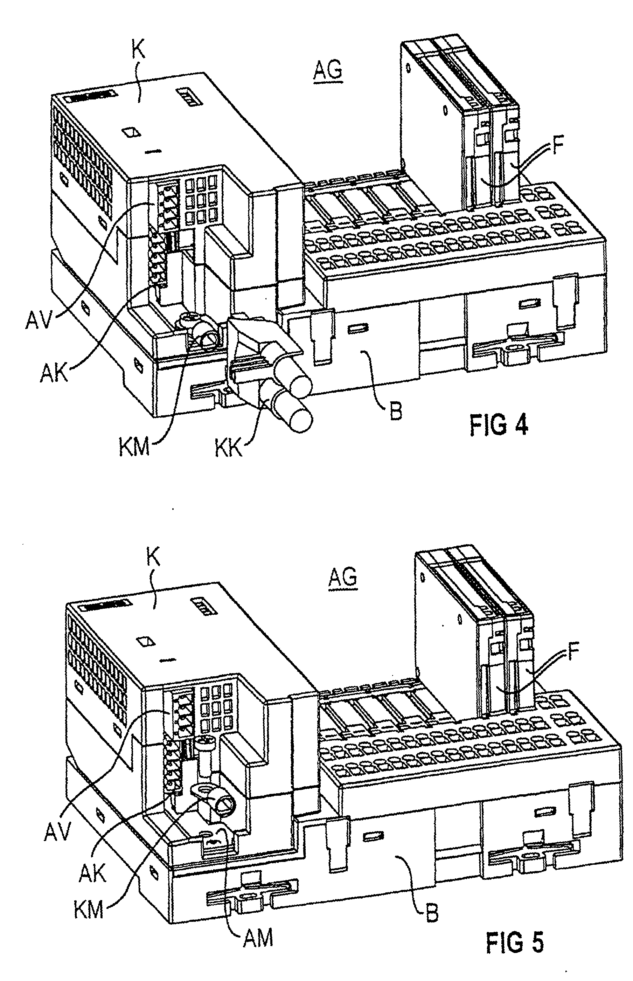

- FIG 4:: Lösen der mechanischen und damit auch der elektrischen Verbindung zum Basismodul B durch Lösen des mit dem Außenanschluß AM zur Heranführung z.B. eines Massespotentials verbundenen Kontaktmittels KM.

Das Montieren erfolgt analog in umgekehrter Reihenfolge. Dabei führt das Herstellen der kommunikativen Verbindung AK, KK vor dem Anschließen der Versorgungsspannung AV, KV dazu, daß zwangsläufig ein definierter Hochlauf der Baugruppe am Bussystem erfolgt. Das Automatisierungsgerät AG nimmt seine Funktion erst mit dem sicheren Anstehen der jeweiligen Versorgungsspannungen auf. Zu diesem Zeitpunkt herrschen aufgrund der konstruktionsbedingt zwangsweise bereits zuvor erfolgten kommunikativen Verbindung auf dem Bus - der kommunikativen Verbindung - bereits eingeschwungene Zustände. Ein vergleichbares Verhalten ist gegenwärtig bei marktüblichen Automatisierungsgeräten nur über ein speziell dafür vorgesehenes Schaltelement auf der Baugruppe, das ein zentrales Ab/Zu-Schalten der Logikspannung auslöst, oder einen Softwarereset möglich.

Zusammenfassend läßt sich die vorliegende Erfindung wie folgt beschreiben: Es wird ein feldbusgesteuertes Automatisierungsgerät AG zur Steuerung und/oder Überwachung des technischen Prozesses mit einem Basismodul B, einem Kopfmodul K mit Außenkontakten und mindestens einem Funktionsmodul F ohne Außenkontakte angegeben, wobei das Kopfmodul K bzw. das Funktionsmodul F mit dem Basismodul B elektrisch leitend kontaktierbar ist. Damit steht ein feldbusgesteuertes Automatisierungsgerät AG zur Verfügung, welches sowohl kompakt als auch kanalgranular aufgebaut werden kann und dabei jeweils eine stehende Verdrahtung bietet, so daß das Auswechseln einzelner Komponenten jederzeit leicht und effektiv möglich ist.

## Patentansprüche

1. Feldbusgesteuertes Automatisierungsgerät (AG) zur Steuerung und/oder Überwachung eines technischen Prozesses mit einem Basismodul (B), einem Kopfmodul (K) mit Außenkontakten und mindestens einem Funktionsmodul (F) ohne Außenkontakte, wobei das Kopfmodul (K) bzw. das Funktionsmodul (F) mit dem Basismodul (B) elektrisch leitend kontaktierbar ist,
- wobei die Außenkontakte das Kopfmoduls (K) zum Anschließen einer Spannungsversorgung und/oder zum kommunikativen Verbinden mit weiteren elektrischen Geräten vorgesehen sind und wobei das Kopfmodul (K) zur Ansteuerung des mindestens einen Funktionsmoduls (F) wirksam ist,
- wobei das Basismodul (B) Außenkontakte zum Anschließen externer Geräte - insbesondere Aktoren oder Sensoren zur Steuerung und/oder Überwachung des technischen Prozesses - aufweist, die einem Funktionsmodul (F) räumlich zugeordnet sind und mit diesem elektrisch leitend verbunden sind,
- wobei die Außenkontakte des Kopfmoduls (K) räumlich zueinander so angeordnet sind, daß sich beim Kontaktieren der Außenkontakte ein konstruktionsbedingt zwangsweiser Handlungsablauf ergibt.

2. Feldbusgesteuertes Automatisierungsgerät nach Anspruch 1, **dadurch gekennzeichnet, daß** das Basismodul (B) Aufnahmepositionen (P) zur Aufnahme des mindestens einen Funktionsmoduls (F) aufweist, die eine bündige Anordnung benachbarter Funktionsmodule (F) ermöglicht.

3. Feldbusgesteuertes Automatisierungsgerät nach Anspruch 1, **dadurch gekennzeichnet, daß** ein elektrisches bzw. mechanisches Kontaktieren bzw. Dekontaktieren des Kopfmoduls (K) mit dem Basismodul (B) nur unter Einhaltung des konstruktionsbedingt zwangsweisen Handlungsablaufs beim Kontaktieren bzw. Dekontaktieren der Außenanschlüsse des Kopfmoduls (K) möglich ist.

## Claims

1. Field bus controlled automation unit (AG) for control and/or monitoring of a technical process with a basic module (B), a head module (K) with external contacts and at least one functional module (F) without external contacts, with the head module (K) or the functional module (F) being able to make conductive electrical contact with the basic module (B),
- with the external contacts of the head module (K) being provided for the connection of a power supply and/or for communication connection to other electrical equipment and with the head module (K) being effective for the control of at least one functional module (F),
- with the basic (B) having external contacts for connection to external equipment, particularly actuators or sensors for control and/or monitoring of the technical process, that are spatially assigned to a functional module (F) and conductively electrically connected to it,
- with the external contacts of the head module (K) being spatially arranged relative to each other such that when contacting the external contacts a forced sequence of action results due to the construction.

2. Field bus controlled automation unit according to Claim 1, **characterised in that** the basic module (B) had mounting positions (P) to take at least one function module (F), that enables a flush arrangement of adjacent functional modules (F).

3. Field bus controlled automation unit according to Claim 1, **characterised in that** an electrical or mechanical making or breaking of the contact of the head module (K) to the base module (B) is possible only if the forced sequence of actions due to the construction are complied with when making or breaking the external contacts of the head module (K).

## Revendications

1. Appareil d'automatisation (AG) commandé par bus de champ en vue de commander et/ou de surveiller un processus technique, comportant un module de base (B), un module de tête (K) dotés de contacts extérieurs et au moins un module fonctionnel (F) sans contact extérieur, dans lequel le module de tête (K) ou le module fonctionnel (F) peut être en contact électrique avec le module de base (B),
- dans lequel les contacts extérieurs du module de tête (K) sont prévus pour établir un raccordement à une tension d'alimentation et/ou une liaison de communication avec d'autres appareils électriques et dans lequel le module de tête (K) a pour rôle de commander l'au moins un module fonctionnel (F),
- dans lequel le module de base (B) comporte des contacts extérieurs pour établir un raccordement à des appareils extérieurs, en particulier des actionneurs ou des capteurs, en vue de commander et/ou de surveiller le processus technique, lesquels contacts extérieurs sont associés dans l'espace à un module fonctionnel (F) auquel ils sont reliés électriquement,
- dans lequel les contacts extérieurs du module de tête (K) sont disposés les uns par rapport aux autres dans l'espace de telle façon qu'une procédure est obligatoirement mise en oeuvre selon les exigences de construction lors de la connexion des contacts extérieurs.

2. Appareil d'automatisation commandé par bus de zone selon la revendication 1, **caractérisé en ce que** le module de base (B) a des positions de réception (P) en vue de recevoir l'au moins un module fonctionnel (F), permettant d'agencer à niveau des modules fonctionnels voisins (F).

3. Appareil d'automatisation commandé par bus de zone selon la revendication 1, **caractérisé en ce qu'**une connexion ou déconnexion électrique ou mécanique du module de tête (K) avec le module de base (B) n'est possible qu'en observant la procédure obligatoire selon les exigences de construction lors de la connexion ou de la déconnexion des bornes extérieures du module de tête (K).
